# EUROPEAN PATENT APPLICATION

(11) **EP 4 671 836 A1**
(43) Date of publication of application: **31.12.2025**
(21) Application number: 24184865.4
(22) Date of filing: 27.06.2024
(51) Int. Cl.: G02B 6/12, G02B 6/136, G02B 6/122

(54) **A THERMALLY EFFICIENT INTEGRATED DEVICE**

(71) Applicant: Imec VZW, 3001 Leuven (BE)
(72) Inventor: Coenen, David, 3390 Tielt-Winge (BE); Oprins, Herman, 3020 Herent (BE); Joris, Van Campenhout, 3001 Leuven (BE); Verheyen, Peter, 2560 Nijlen (BE); Ban, Yoojin, 3001 Heverlee (BE); Kim, Minkyu, 3010 Kessel-Lo (BE); Ferraro, Filippo Jacopo, 1040 Etterbeek (BE); Miller, Robert, 3210 Lubbeek (BE); Absil, Philippe, 1471 Loupoigne (BE); Velenis, Dimitrios, 1320 Nodebais (BE)
(74) Representative: Roth, Sebastian

(57) **Abstract**

The disclosure relates to electronic-photonic systems. The disclosure proposes an integrated device, and a corresponding method for manufacturing the integrated device. The integrated device comprises an electronic integrated circuit (EIC) and a photonic integrated circuit (PIC) bonded and electrically connected to the EIC, wherein the PIC comprises a waveguide and a heater configured to heat the waveguide. The integrated device comprises one or more cavities arranged between the heater and the EIC for thermally isolating the heater from the EIC.

## Description

### TECHNICAL FIELD

The present disclosure relates to electronic-photonic systems. The disclosure proposes an integrated device, and a corresponding method for manufacturing the integrated device. The integrated device comprises a heater and thermally isolates the heater in a new way.

### BACKGROUND

Photonic integrated circuits (PICs) used in optical transceivers may, for example, employ ring-based devices for light modulation and filtering. As those devices rely on the resonance of light, they are extremely sensitive to changes in operating conditions. This includes a significant temperature sensitivity due to the high thermo-optic coefficient of silicon (1.9E-4 1/K). In order to lock the ring-based devices to the correct temperature, they are equipped with integrated heaters (metal or doped Si). These heaters may consume a considerable fraction of the total energy budget and therefore are subject to thermal design optimization, with the objective of lowering the energy consumption.

### SUMMARY

In view of the above, an objective of this disclosure is to provide an integrated electronic-photonic device comprising a heater that is thermally efficient.

This and other objectives are achieved by the solutions of this disclosure as described in the independent claims. Advantageous implementations are further described in the dependent claims.

The solutions of this disclosure are based on the following considerations.

Conventional devices may move towards highly integrated electronic-photonic systems in so-called copackaged optics (CPO), to reduce parasitic losses in data transfer between a host IC and an optical transceiver. This integration may be achieved by 3-dimensional (3D) stacking of an electronic integrated circuit (EIC) on top of a PIC. This has a direct impact on the heater efficiency in the photonic devices. In particular, bonding a die on top of the PIC results in heat loss through the bonding layer between PIC and EIC. The solutions of this disclosure address this issue by introducing new design features that enhance the thermal isolation between both the PIC and EIC.

Additionally, in an advanced packaging configuration, a PIC substrate, for example, a silicon (Si) substrate, may be removed by substrate thinning, such that optical coupling between a PIC waveguide and an underlying optical interposer may be possible. However, this means that the conventionally used substrate undercut may no longer be possible under the heated ring device, which may be done to thermally isolate the device from the substrate. Thus, the thermal isolation between the PIC and the optical interposer below maybe improved by the solutions of this disclosure.

A first aspect of this disclosure provides an integrated device comprising an EIC and a PIC bonded and electrically connected to the EIC, wherein the PIC comprises a waveguide and a heater configured to heat the waveguide, and wherein the integrated device comprises one or more cavities arranged between the heater and the EIC for thermally isolating the heater from the EIC.

In this way, the thermal isolation of the heater may be improved, for example, compared to conventional integrated electronic-photonic devices.

The heater may be arranged between the waveguide and the EIC.

The integrated device may comprise a substrate, wherein the PIC may be arranged between the substrate and the EIC.

The one or more cavities may or may not be arranged in at least the PIC, for example, may be entirely in the PIC or not.

A direction from the heater to the EIC may be denoted a vertical direction. The EIC may be arranged in the vertical direction above the PIC.

The one or more cavities may not thermally isolate the heater from the waveguide.

In an implementation form of the first aspect, the one or more cavities are configured to reflect 20% to 80% of an entire amount of thermal energy flowing from the heater towards the EIC and/or from the EIC towards the waveguide.

For example, the one or more cavities maybe configured to reflect 20% to 80% of an entire amount of thermal energy flowing from the heater towards the EIC.

The EIC maybe a larger size heat source compared to the footprint of the TOPCUT. Thus, the TOPCUT may block a smaller percentage of thermal energy flowing from the EIC towards the waveguide compared to a percentage of thermal energy flowing from the heater towards the EIC.

The one or more cavities maybe arranged and/or configured based on the required specifications of the integrated device. For example, the dimensions of the one or more cavities may be increased to improve the thermal isolation. In another example, the dimensions of the one or more cavities may be reduced to improve a structural integrity of the integrated device. For example, the one or more cavities may be separated into two or more cavities to improve the structural integrity.

The one or more cavities may be configured to thermally isolate both the heater and the EIC.

In a further implementation form of the first aspect, the integrated device further comprises one or more bonding layers configured to bond and electrically connect the EIC to the PIC.

In a further implementation form of the first aspect, the one or more bonding layers are hybrid bonding layers.

Thus, the PIC and EIC may be efficiently electrically connected, while the thermal isolation of the heater may be improved.

In a further implementation form of the first aspect, the one or more cavities are arranged in at least the one or more bonding layers, for example, entirely in the one or more bonding layers.

Thus, the heater may be thermally efficient, the PIC and EIC may be efficiently electrically connected, and the integrated device may be mechanically stable.

In a further implementation form of the first aspect, the PIC comprises a metal layer provided on a particular layer, wherein the metal layer is configured to electrically connect one or more components in the particular layer, wherein the one or more cavities are arranged in at least the metal layer, for example, entirely in the metal layer.

Thus, the one or more cavities may be particularly thermally isolating.

The metal layer may be arranged between the heater and the EIC.

The metal layer may be a Metal 1 (M1) layer. The M1 layer may be the first layer of metal interconnects deposited during the fabrication process of integrated circuits and photonic devices. This layer may be used to create electrical connections between different components of the device.

The one or more components in the particular layer may be two or more components in the particular layer.

In a further implementation form of the first aspect, the PIC comprises a via layer comprising at least one via, wherein the one or more cavities are arranged in at least the via layer, for example, entirely in the via layer.

Thus, the one or more cavities may be particularly thermally isolating, while the PIC and EIC may be efficiently electrically connected.

The via layer may be arranged between the heater and the EIC. For example, the via layer may be arranged between a metal 1 (M1) layer and the EIC.

In a further implementation form of the first aspect, the one or more cavities are arranged in at least a back-end-of-line part of the PIC, for example, entirely in the back-end-of-line part of the PIC.

In a further implementation form of the first aspect, the one or more cavities are two or more cavities that are separated by one or more material pillars.

Thus, the structural integrity of the integrated device may be improved.

The one or more material pillars may separate at least two cavities of the two or more cavities by more than 500 nm.

The same as above may apply to the one or more other cavities and/or the one or more further cavities.

In a further implementation form of the first aspect, the one or more cavities are at least one of: under vacuum, filled with air, filled with a gas, filled with a material that has lower thermal conductivity than a substrate included in the PIC and/or a substrate included in the one or more bonding layers, if present, and filled with a material that has thermal conductivity below 1.2 W m⁻¹ K⁻¹.

For example, the one or more cavities may be under vacuum or filled with air.

The same as above may apply to the one or more other cavities and/or the one or more further cavities.

In a further implementation form of the first aspect, each cavity of the one or more cavities respectively has a length in a range of 10 µm to 50 µm in a direction that is perpendicular to a direction that extends from the heater to the EIC.

The same as above may apply to the one or more other cavities and/or the one or more further cavities.

In a further implementation form of the first aspect, the one or more cavities are arranged above the waveguide, and wherein the integrated device further comprises one or more other cavities that are arranged below the waveguide for thermally isolating the heater.

The integrated device may comprise one or more other bonding layers, for example, one or more other hybrid bonding layers, arranged below the waveguide. For example, the integrated device may comprise the one or more other bonding layers instead of a substrate.

The one or more other cavities may or may not be arranged in at least the one or more other bonding layers.

The one or more cavities and the one or more other cavities may be fabricated similarly, for example according to the second aspect or its implementation forms, wherein the one or more other cavities may be formed on the vertically opposite side of the integrated device than the one or more cavities.

In a further implementation form of the first aspect, the one or more cavities are arranged above the waveguide, wherein the one or more other cavities, if present, are arranged below the waveguide for thermally isolating the heater and/or the substrate, if present, is arranged below the waveguide, and wherein the integrated device further comprises one or more further cavities that are arranged sideways from the waveguide for thermally isolating the heater.

The one or more further cavities may be etched trenches on the side of the waveguide and/or heater for thermally isolating the heater.

The one or more further cavities and the one or more cavities may or may not be fabricated similarly, for example according to the second aspect or its implementation forms, wherein the one or more further cavities may be formed sideways of the waveguide.

A second aspect of this disclosure provides a method of manufacturing an integrated device, the method comprising: forming an EIC; forming a PIC comprising a waveguide and a heater configured to heat the waveguide; and bonding and electrically connecting the EIC to the PIC; wherein one or more cavities are formed between the heater and the EIC for thermally isolating the heater from the EIC.

For example, the method may comprise forming the one or more cavities between the heater and the EIC.

The bonding and electrically connecting the EIC to the PIC may be based on one or more bonding layers, for example, hybrid bonding layers.

In an implementation form of the second aspect, the method further comprises: forming a first bonding layer on the PIC, forming a second bonding layer on the EIC, and forming the one or more cavities by etching the one or more cavities into the first bonding layer, wherein bonding and electrically connecting the EIC to the PIC comprises bonding the first bonding layer to the second bonding layer after etching the one or more cavities into the first bonding layer.

The one or more cavities may be at least partially, for example, entirely, enclosed in the integrated device by bonding the first bonding layer to the second bonding layer.

The first bonding layer and the second bonding layer may be hybrid bonding layers.

In a further implementation form of the second aspect, forming the PIC comprises forming one or more sacrificial regions comprising a sacrificial material in the PIC, and wherein the method further comprises forming the one or more cavities by: exposing the one or more sacrificial regions by etching one or more trenches, and removing the sacrificial material in the one or more sacrificial regions by using a selective etchant.

The method of the second aspect may have implementation forms that correspond to the implementation forms of the integrated device of the first aspect. The method of the second aspect and its implementation forms achieves the advantages and effects described above for the integrated device of the first aspect and its respective implementation forms.

Further, in this disclosure, forming or providing a layer "on" another layer may mean growing or depositing these layers one upon the other. Thus, surfaces of these layers may be in contact. Forming a layer "*above*" another layer may mean that this layer is formed after the other layer (in the growth or deposition direction of the device fabrication), but there may be formed one or more layers in between.

Further, in this disclosure, forming a layer "*below*" another layer may mean that this layer is formed before the other layer (in the growth or deposition direction of the device fabrication), but there may be formed one or more layers in between.

Further, in this disclosure, the phrase "*above*" and/or "*below*" when referring to a physical location may refer to a vertical direction, wherein the extension direction of the waveguide core is perpendicular to the vertical direction and a horizontal direction.

Further, in this disclosure, a direction from the heater to the EIC may be denoted a vertical direction.

Further, in this disclosure, a component, another component, and a further component are considered to be different components, if not explicitly mentioned otherwise.

### BRIEF DESCRIPTION OF DRAWINGS

The above-described aspects and implementation forms will be explained in the following description of specific embodiments in relation to the enclosed drawings, in which
- FIG. 1: shows schematically an integrated device according to this disclosure.
- FIG. 2: shows cavities in an integrated device according to this disclosure.
- FIG. 3: shows an exemplary integrated device comprising a TOPCUT in a M1 layer according to this disclosure.
- FIG. 4: shows an exemplary integrated device comprising a TOPCUT in a via layer according to this disclosure.
- FIG. 5: shows an exemplary integrated device comprising a TOPCUT with support pillars according to this disclosure.
- FIG. 6: shows an exemplary integrated device comprising a TOPCUT in a bonding layer according to this disclosure.
- FIG. 7: shows an exemplary method step for fabricating a TOPCUT according to this disclosure.
- FIG. 8: shows an exemplary method step for fabricating a TOPCUT according to this disclosure.
- FIG. 9: shows an exemplary method step for fabricating a TOPCUT with a SIDECUT according to this disclosure.
- FIG. 10: shows an exemplary method step for fabricating a TOPCUT with a SIDECUT according to this disclosure.
- FIG. 11: shows an exemplary method step for fabricating a TOPCUT with a SIDECUT according to this disclosure and a conventional UCUT.
- FIG. 12: shows a cross-section for respectively a conventional device and integrated device comprising a TOPCUT according to this disclosure.
- FIG. 13: shows an exemplary heater efficiency of a disk modulator with a conventional UCUT and a TOPCUT with a variable size and thickness according to this disclosure.
- FIG. 14: shows an exemplary heater efficiency according to this disclosure and according to conventional devices.
- FIG. 15: shows a flow-diagram of a method according to this disclosure.

### DETAILED DESCRIPTION OF EMBODIMENTS

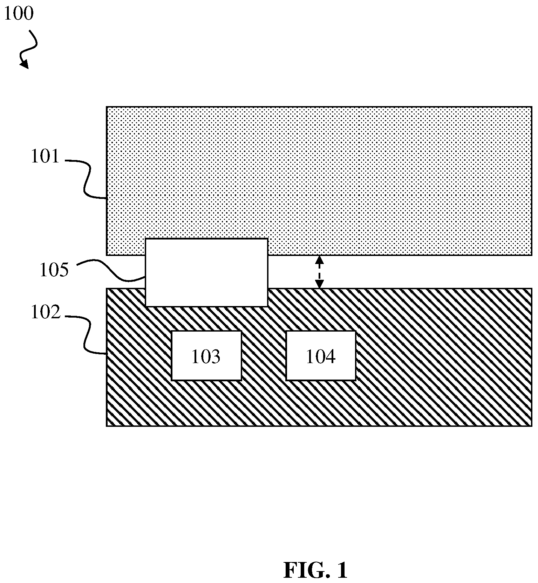

FIG. 1 shows an integrated device 100 according to this disclosure. The integrated device 100 comprises an EIC 101 and a PIC 102. The PIC 102 is bonded and electrically connected to the EIC 101, which is indicated by the dashed arrow in FIG. 1. A PIC may generally be a device configured to use light to transmit data, and may for example comprise components like lasers and waveguides on a single chip for faster and more efficient communication. An EIC may generally be a device configured to use electrical signals to process data, and may for example comprise components like transistors and capacitors on a single chip for efficient computing.

The PIC 102 of the integrated device 100 comprises a waveguide 103 and a heater 104, wherein the heater 104 is configured to heat the waveguide 103. The integrated device 100 comprises one or more cavities 105 arranged between the heater 104 and the EIC 101 for thermally isolating the heater 104 from the EIC 101. For example, the heater 104 may be arranged between the waveguide 103 and the EIC 101. The one or more cavities 105 may not thermally isolate the heater 104 from the waveguide 103.

Thermal isolation of the heater 104 of the integrated device 100 may be improved, for example, compared to conventional integrated electronic-photonic devices.

The integrated device 100 may further comprise a substrate, wherein the PIC 102 may be arranged between the substrate and the EIC 101.

By means of the cavities 105, thermal isolation features are introduced, with the objective of limiting the heat loss. The integrated device 100 may include different cavities 105, 111, 112, 113 in the cross-section of the integrated device 100, which may for example be formed based on a silicon (Si) photonics wafer.

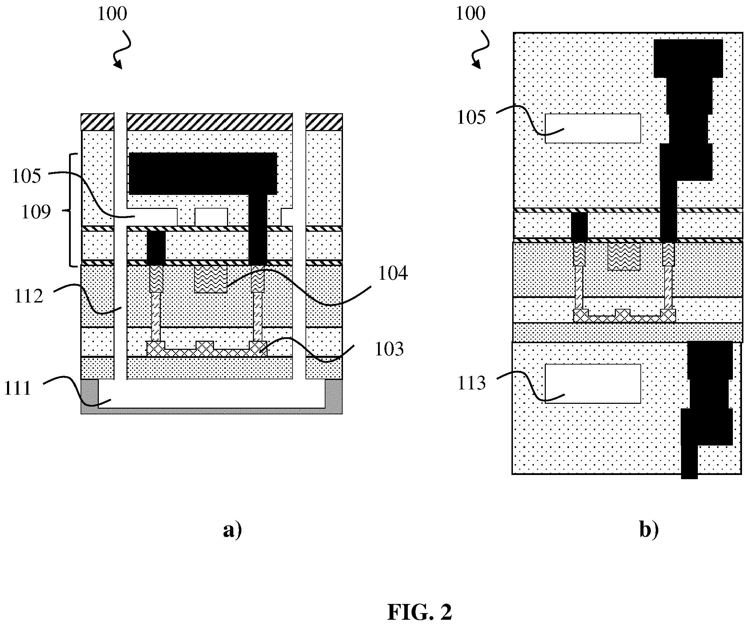

FIG. 2 shows different cavities 105, 111, 112, 113 in an integrated device 100 according to this disclosure. The integrated device 100 comprises a waveguide 103 and a heater 104.

FIG. 2a shows a TOPCUT (cavity) 105 above the waveguide layer in the PIC 102 back-end-of-line (BEOL) 109, a SIDECUT 112, and a conventional UCUT 111.

FIG. 2b shows a TOPCUT 105 above the waveguide layer in the one or more bonding layers 106 and an UNDERCUT 113.

A TOPCUT 105 may be defined as a cavity 105 above the waveguide layer, for example, in the BEOL 109 of the PIC 102 or in the one or more bonding layers 106.

A SIDECUT 112 may be defined as a further cavity 112 laterally from the waveguide 103.

An alternative to a conventional UCUT 111 may be an UNDERCUT 113. An UNDERCUT 113 may be defined as another cavity 113, for example, in one or more other bonding layers, below the waveguide 103.

The implementation of a TOPCUT 105 with a SIDECUT 112 mainly aims to reduce the vertical heat loss into the bonded EIC 101 on top of the PIC 102. The UNDERCUT 113 in the one or more other bonding layers below the waveguide 103 may aim to replace a conventional UCUT 111, which may no longer be possible after substrate thinning.

Fabricating a TOPCUT 105 or the one or more cavities 105 may include the process of material removal above the waveguide 103, for example, in the metallization layers or a hybrid bonding layer. Fabricating a SIDECUT 112 may include the process of removing material lateral from the waveguide 103, and fabricating an UNDERCUT 113 may include the removal of material below the waveguide 103 in hybrid bonding layers 106.

The waveguide 103 may be a Si waveguide 103. The one or more bonding layers 106 may be a hybrid bonding layer. The one or more other bonding layers may be a hybrid bonding layer.

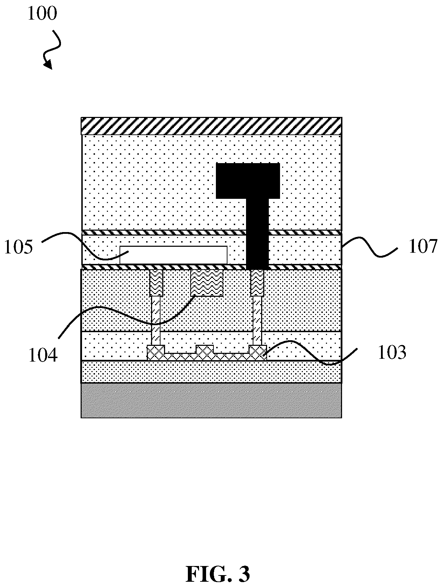

FIG. 3 shows an exemplary integrated device 100 comprising a TOPCUT 105 in a M1 layer 107 according to this disclosure. The integrated device 100 comprises a waveguide 103 and a heater 104. The heater 104 may be arranged between the waveguide 103 and the one or more cavities 105, wherein the one or more cavities 105 may be arranged in close proximity in the vertical direction above the heater 104 to improve thermal isolation of the heater with respect to the EIC 101.

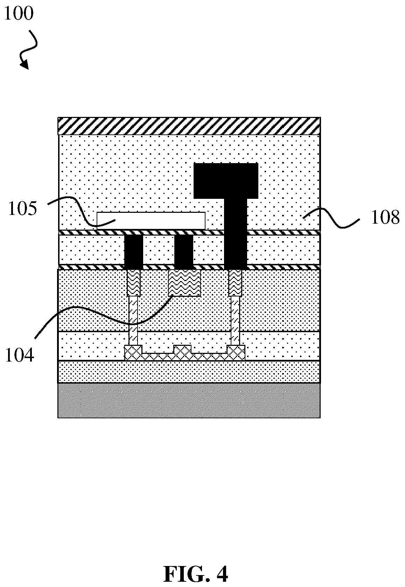

FIG. 4 shows an exemplary integrated device 100 comprising a TOPCUT 105 in a via layer 108, according to a solution of this disclosure. The integrated device 100 comprises a waveguide 103 and a heater 104. To improve electrical conductivity, the one or more cavities 105 may be arranged in the via layer 108.

The via layer 108 may, for example, be arranged above the M1 layer 107.

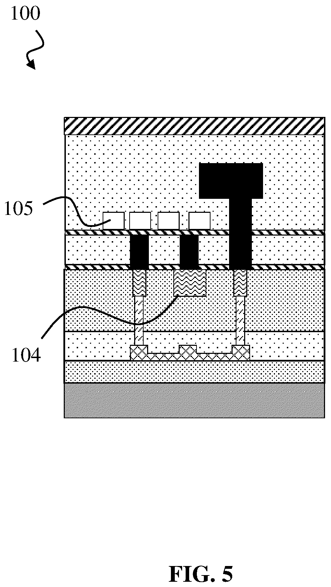

FIG. 5 shows an exemplary integrated device 100 comprising a TOPCUT 105 with support pillars, according to a solution of this disclosure. The integrated device 100 comprises a waveguide 103 and a heater 104. The support pillars may separate a plurality of cavities 105. Thus, structural stability may be increased by the support pillars, while thermal isolation may be increased by the plurality of cavities 105.

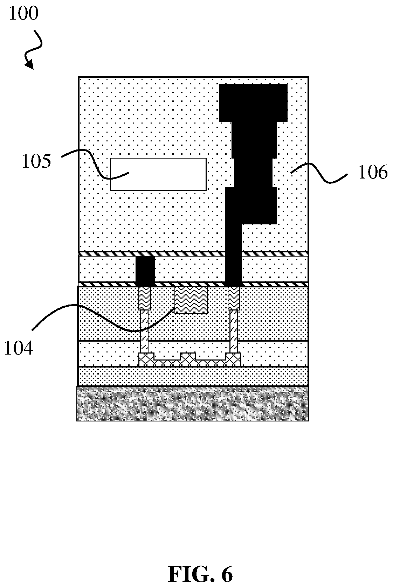

FIG. 6 shows an exemplary integrated device 100 comprising a TOPCUT 105 in a bonding layer 106, according a solution of this disclosure.

Fabrication of the integrated device 100 may be improved due to the ease of fabrication of a TOPCUT 105 in the bonding layer 106.

The integrated device 100 may comprise one or more barrier or dielectric layers. For example, FIGs. 2 to 6 show a first barrier or dielectric layer that is arranged between the heater 104 and the metal layer 107, for example, the M1 layer 107. Further, FIGs. 2 to 6 show a second barrier or dielectric layer that is arranged between the metal layer 107 and the via layer 108.

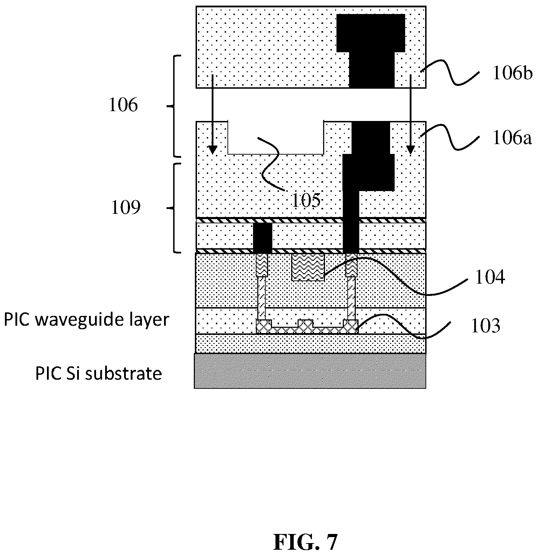

FIG. 7 shows an exemplary method step for fabricating a TOPCUT 105, according to a solution of this disclosure. A cavity 105 may be etched in the one or more bonding layers 106, for example, a hybrid bonding oxide, prior to bonding.

For example, the TOPCUT 105 can be fabricated as follows: after processing the one or more bonding layers 106, 106a, 106b on the PIC 102 and the EIC 101, a first bonding layer 106a, for example, an oxide of the first bonding layer 106a, on the PIC 102 may be patterned and etched to create a cavity 105. Then, the hybrid bonding process may be resumed to create a closed cavity 105 by bonding the first bonding layer 106a on the PIC 102 to a second bonding layer 106b on the EIC 101.

Alternatively or additionally, the one or more cavities 105 may be fabricated based on other methods.

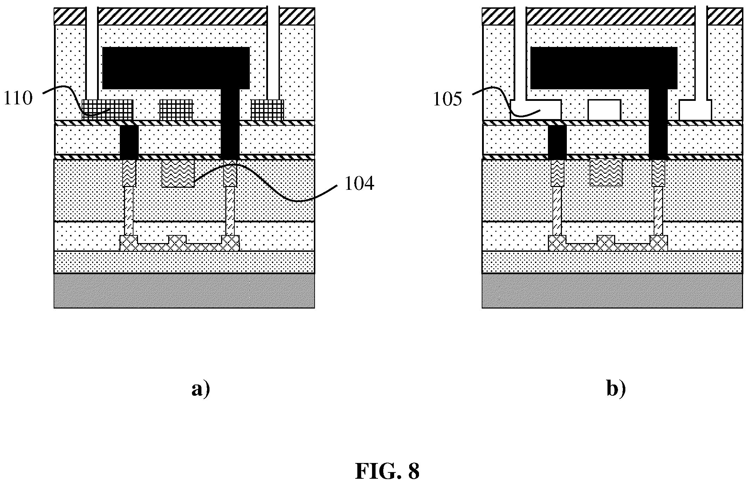

FIG. 8 shows an exemplary method step for fabricating a TOPCUT 105, according to a solution of this disclosure. One or more sacrificial layers 110 may be included in the PIC 102 BEOL 109. After exposing the layers with an etch trench, the one or more sacrificial layers 110 may be removed with a selective etchant.

For example, the TOPCUT 105 may be provided inside the metallization layers of the PIC 102. For example, this maybe done as follows: during the processing of the metallization layers, a sacrificial material may be included in the material stack. After all PIC 102 layers have been processed, the sacrificial layer 110 may be exposed by creating an etch trench. Then, a selective etchant may remove the sacrificial material of the sacrificial regions 110 to create the TOPCUT 105. Afterwards, the etched trenches may or may not be sealed, depending on the packaging requirements of the PIC 102.

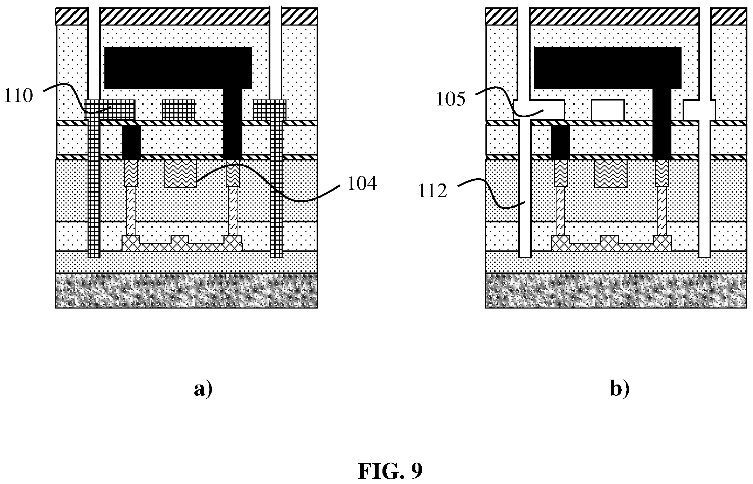

FIG. 9 shows an exemplary method step for fabricating a TOPCUT 105 with a SIDECUT 112, according to a solution of this disclosure. One or more sacrificial layers 110 may be included starting from the waveguide layer, and may be removed with a selective etchant.

For example, the TOPCUT 105 shown in FIG. 8 may be made in combination with a SIDECUT 112. During processing of the PIC 102, trenches may be formed prior to the deposition of the sacrificial material. After trench formation, the sacrificial material may be deposited. The trenches may be sealed, but may or may not be filled completely in order to allow further processing. After processing all the PIC 102 layers, the sacrificial material of the sacrificial regions 110 maybe exposed and removed with a selective etchant.

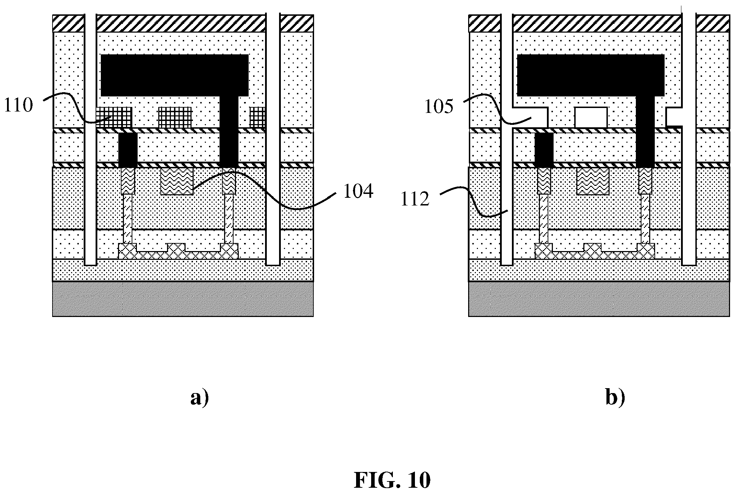

FIG. 10 shows an exemplary method step for fabricating a TOPCUT 105 with a SIDECUT 112, according to a solution of this disclosure.

Instead of including sacrificial material down to the waveguide layer, etch trenches maybe made, for example, in the oxide, from the BEOL 109 down to the waveguide layer, exposing the side of the sacrificial regions 110. Then, the TOPCUT 105 sacrificial material may be removed with a selective etchant.

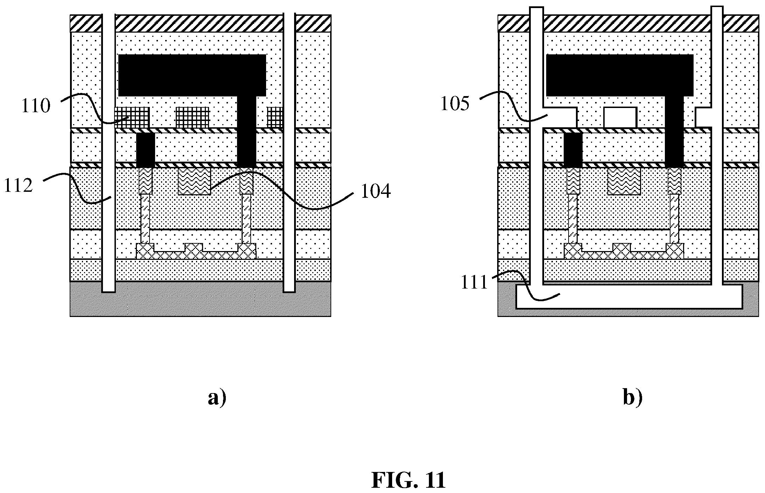

FIG. 11 shows an exemplary method step for fabricating a TOPCUT 105 with a SIDECUT 112, according to a solution of this disclosure and a conventional UCUT 111. Etch trenches may be made from the BEOL 109 down to a substrate, for example, Si substrate. A selective etchant may remove the sacrificial layers 110 and the substrate below the waveguide 103.

For example, a TOPCUT 105 may be made in combination with a SIDECUT 112 and a conventional UCUT 111 in the following way: the etch trenches maybe made such that they penetrate a buried oxide below the Si waveguide layer and expose the Si substrate below. Then, a selective etchant may remove the TOPCUT 105 sacrificial layer iio and the Si substrate below the waveguide 103. Potentially a different selective etchant may be used for both layers, as long as both are compatible with the exposed materials from the PIC 102 stack.

In advanced packaging configurations where the substrate of the PIC 102 is removed, a conventional UCUT 111 may no longer be possible. Thus, an UNDERCUT 113, for example, as shown in FIG. 2b, may be made in one or more other bonding layers below the waveguide 103 to mimic the effect of a conventional UCUT 111.

The UNDERCUT 113 may be formed by one or more other cavities 113. After a PIC 102 substrate removal, bonding layers, for example, hybrid bonding layers, maybe processed on a PIC 102 bottom side. Part of a bonding layer material, for example, oxide, may be etched prior to bonding.

The process of fabricating an UNDERCUT 113 may be similar to the process of a TOPCUT 105 as discussed above except that it may be carried out on the PIC 102 bottom side, for example, below the waveguide 103.

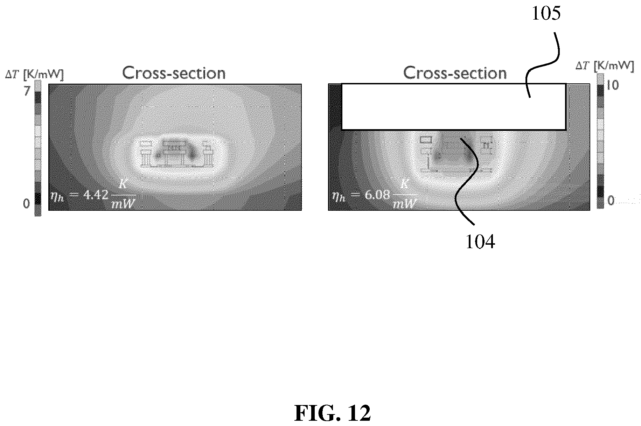

FIG. 12 shows a cross-section for a conventional device and integrated device 100 comprising a TOPCUT 105, according to a solution of this disclosure. In this example the heater 104 efficiency is increased by +37.55%.

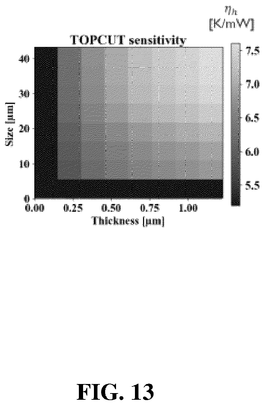

FIG. 13 shows an exemplary heater 104 efficiency of a disk modulator with a conventional UCUT 111 and a TOPCUT 105 with a variable size and thickness, according to a solution of this disclosure.

In this example, the TOPCUT 105 size varies from 0 to 42 µm and the TOPCUT 105 thickness varies from 0 to 1.2 µm. The thickness may be in the vertical direction and the size may be in a direction perpendicular to the vertical direction.

For example, in the case of maximum TOPCUT 105 size and thickness, the heater 104 efficiency may increases by +50% relative to the case with only a conventional UCUT 111.

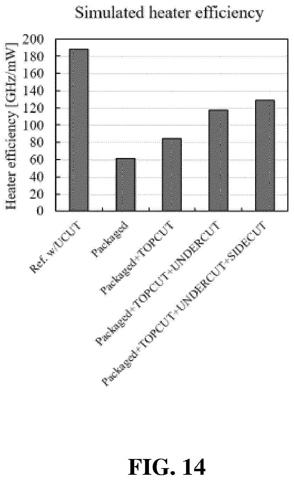

FIG. 14 shows an exemplary heater 104 efficiency according to a solution of this disclosure and for conventional devices.

FIG. 14 shows the heater 104 efficiency of a conventional device with a UCUT 111 and no 3D packaging. Packaging may impose a large penalty on efficiency and may remove the option for a conventional UCUT 111. Thus, in a fully 3D packaged configuration, a large penalty on heater 104 efficiency may be expected. Heat loss may occur through the bonding layers and a conventional UCUT 111 may no longer be possible. An integrated device 100 may limit this penalty.

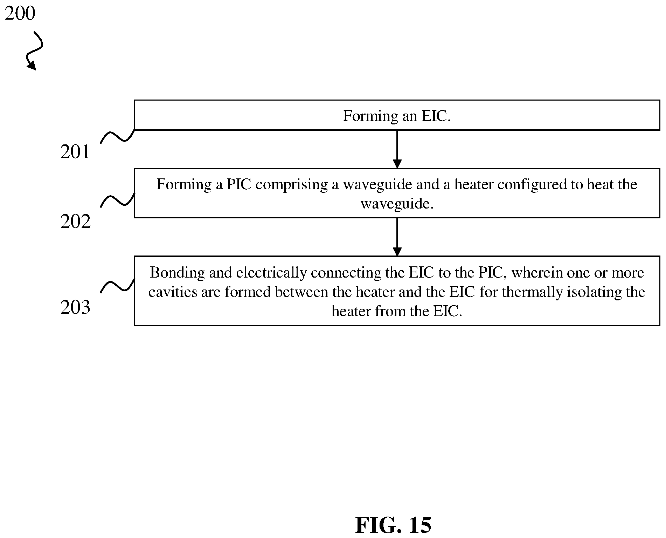

FIG. 15 shows a flow-diagram of a method 200 according to this disclosure. The method 200 is a method of manufacturing an integrated device 100.

The method 200 comprises a step 201 of forming an EIC 101. Further, the method 200 comprises a step 202 of forming a photonic PIC 102 comprising a waveguide 103 and a heater 104 configured to heat the waveguide 103. Further, the method 200 comprises a step 203 of bonding and electrically connecting the EIC 101 to the PIC 102, wherein one or more cavities 105 are formed between the heater 104 and the EIC 101 for thermally isolating the heater 104 from the EIC 101.

The disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. An integrated device (100) comprising an electronic integrated circuit, EIC, (101) and a photonic integrated circuit, PIC, (102) bonded and electrically connected to the EIC (101),
wherein the PIC (102) comprises a waveguide (103) and a heater (104) configured to heat the waveguide (103), and
wherein the integrated device (100) comprises one or more cavities (105) arranged between the heater (104) and the EIC (101) for thermally isolating the heater (104) from the EIC (101).

2. The integrated device (100) according to claim 1,
wherein the one or more cavities (105) are configured to reflect 20% to 80% of an entire amount of thermal energy flowing from the heater (104) towards the EIC (101) and/or from the EIC (101) towards the waveguide (103).

3. The integrated device (100) according to claim 1 or 2,
further comprising one or more bonding layers (106) configured to bond and electrically connect the EIC (101) to the PIC (102).

4. The integrated device (100) according to claim 3, wherein the one or more bonding layers (106) are hybrid bonding layers.

5. The integrated device (100) according to claim 3 or 4,
wherein the one or more cavities (105) are arranged in at least the one or more bonding layers (106).

6. The integrated device (100) according to any one of the preceding claims,
wherein the PIC (102) comprises a metal layer (107) provided on a particular layer, wherein the metal layer (107) is configured to electrically connect one or more components in the particular layer,
wherein the one or more cavities (105) are arranged in at least the metal layer (107).

7. The integrated device (100) according to any one of the preceding claims,
wherein the PIC (102) comprises a via layer (108) comprising at least one via,
wherein the one or more cavities (105) are arranged in at least the via layer (108).

8. The integrated device (100) according to any one of the preceding claims,
wherein the one or more cavities (105) are arranged in at least a back-end-of-line part (109) of the PIC (102).

9. The integrated device (100) according to any one of the preceding claims,
wherein the one or more cavities (105) are two or more cavities that are separated by one or more material pillars.

10. The integrated device (100) according to any one of the preceding claims,
wherein the one or more cavities (105) are at least one of:
under vacuum,
filled with air,
filled with a gas,
filled with a material that has lower thermal conductivity than a substrate included in the PIC (102) and/or a substrate included in the one or more bonding layers (106), if present, and
filled with a material that has thermal conductivity below 1.2 W m⁻¹ K⁻¹.

11. The integrated device (100) according to any one of the preceding claims,
wherein each cavity of the one or more cavities (105) respectively has a length in a range of 10 µm to 50 µm in a direction that is perpendicular to a direction that extends from the heater (104) to the EIC (101).

12. The integrated device (100) according to any one of the preceding claims,
wherein the one or more cavities (105) are arranged above the waveguide (103), and
wherein the integrated device (100) further comprises one or more other cavities (113) that are arranged below the waveguide (103) for thermally isolating the heater (104).

13. A method of manufacturing an integrated device (100), the method comprising:
forming an electronic integrated circuit, EIC, (101);
forming a photonic integrated circuit, PIC, (102) comprising a waveguide (103) and a heater (104) configured to heat the waveguide (103); and
bonding and electrically connecting the EIC (101) to the PIC (102);
wherein one or more cavities (105) are formed between the heater (104) and the EIC (101) for thermally isolating the heater (104) from the EIC (101).

14. The method according to claim 13,
further comprising:
forming a first bonding layer (106a) on the PIC (102),
forming a second bonding layer (106b) on the EIC (101), and
forming the one or more cavities (105) by etching the one or more cavities (105) into the first bonding layer (106a),
wherein bonding and electrically connecting the EIC (101) to the PIC (102) comprises bonding the first bonding layer (106a) to the second bonding layer (106b) after etching the one or more cavities (105) into the first bonding layer (106a).

15. The method according to claim 13,
wherein forming the PIC (102) comprises forming one or more sacrificial regions (110) comprising a sacrificial material in the PIC (102), and
wherein the method further comprises forming the one or more cavities (105) by:
exposing the one or more sacrificial regions (110) by etching one or more trenches, and
removing the sacrificial material in the one or more sacrificial regions (110) by using a selective etchant.
